# EUROPEAN PATENT SPECIFICATION

(11) **EP 1 345 213 B1**
(45) Date of publication and mention of the grant of the patent: **18.01.2006**
(21) Application number: 03005414.2
(22) Date of filing: 13.03.2003
(51) Int. Cl.: G11B 5/72, G11B 5/84, C23C 4/06, C23C 14/06

(54) **Magnetic recording medium and method and apparatus for manufacturing the same**
Magnetische Aufzeichnungsmedium und Verfahren und Gerät zur Herstellung desselben
Support d'enrégistrement magnétique et méthode et appareil pour la fabrication du même

(30) Priority: 15.03.2002 JP 2002071875
(43) Date of publication of application: 17.09.2003
(73) Proprietor: MATSUSHITA ELECTRIC INDUSTRIAL CO., LTD., Kadoma-shi, Osaka 571-8501 (JP)
(72) Inventor: Takahashi, Kiyoshi, Ibaraki-shi, Osaka 567-0831 (JP); Imamura, Junichi, Tsuyama-shi, Okayama 708-0865 (JP); Imai, Tomofusa, Katsuta-gun, Okayama 708-1311 (JP)
(74) Representative: Vossius & Partner

(56) References cited:
- EP-A- 0 432 536
- EP-A- 0 580 164
- US-A- 5 589 263
- US-A- 5 612 134
- US-A- 6 001 431

## Description

The present invention relates to a magnetic recording medium including a hard carbon film that is formed on a ferromagnetic metal thin film on an insulating base, and a method and an apparatus for manufacturing the magnetic recording medium.

With an increase in magnetic recording density in the field of information recording, not only a recording film but also the performance of a protective film for the recording film has been one of the important basic techniques that determine the product reliability. To provide a magnetic recording medium at low cost, the protective film as well as the recording film must be formed with high speed. The high-speed film formation technology for a recording film has been established by the progress in vacuum deposition. However, a protective film, with which the entire surface of a recording film should be coated without any defect, requires a precise film forming method, and thus sputtering or plasma CVD (chemical vapor deposition) has been studied.

The plasma CVD is advantageous for high-speed film formation because of its high deposition rate, and various proposals have been made as a method for forming the protective film. To ensure the reliability by improving the quality of a film produced by plasma CVD, it is necessary to form the film with high energy. However, the high-energy film formation uses a high current, so that a resistance roller for supplying a current to the recording film needs to have many points of current passage.

For a generally used metallic roller, the resistance of a contact point is extremely low. Therefore, a current value per contact point is increased to cause the generation of Joule heat due to a contact resistance of the contact point and/or a resistance of the recording film. The Joule heat contributes to the damage of an insulating base and/or the recording film and the defect of the protective film itself, which increases recording/reproducing defects of the recording film. When a medium having these defects is left in the environment of high temperature and high humidity, oxidation starts from any defective portion in the recording film. This makes, e.g., recording or reproduction impossible and significantly degrades the reliability. To address such a problem, a technique has been proposed that uses a resistance roller with a proper surface resistance and supplies a current to a recording film through the resistance roller so as to form a protective film. This technique has solved the problem about the reliability of a magnetic recording medium used under general conditions.

However, when the magnetic recording medium is used under severe working conditions, e.g., in a helical-scan video tape recorder carrying a small high-speed rotating cylinder, a dropout or error ratio is increased by minor defects. After the magnetic recording medium has been kept in the environment of high temperature and high humidity, the dropout is increased largely by a reduction in adhesion strength to the recording film and in film quality of the protective film. An example of the helical-scan video tape recorder is proposed by JP 4(1992)-236588 A.

US-5,589,263 relates to a ferromagnetic metal thin film recording medium having a nonmagnetic substrate, a ferromagnetic metal thin film formed on the nonmagnetic substrate, a dry etched layer which is formed in a surface layer of the ferromagnetic metal thin film and contains oxygen atoms in a higher concentration than the remaining part of the ferromagnetic metal thin film, a hard carbonaceous film formed on the dry etched layer of the ferromagnetic metal thin film, a lubricant layer formed on said hard carbonaceous film, and optionally a modified layer which is formed on the hard carbonaceous film and has a thickness of less than 3 nm, and comprises carbon, nitrogen and oxygen atoms with an atomic ratio of nitrogen to carbon being at least 0.8%, which recording medium has improved running stability, durability and weatherability while maintaining electromagnetic conversion characteristics.

From EP-A-0 432 536, a magnetic recording medium and method for making it is known. In making a magnetic recording medium, a diamond-like carbon film is formed stably with high product efficiency such as 200 Å/sec, without occurrence of irregular discharge, and still improved durability and reduced head contamination are achieved by utilizing a.c. plasma discharge or a.c. plasma discharge superimposed by d.c. power and a lubricant film.

Therefore, with the foregoing in mind, it is an object of the present invention to provide a magnetic recording medium that can maintain high reliability even under severe working conditions, and a method and an apparatus for manufacturing the magnetic recording medium.

The object is achieved by the features of the claims.

A magnetic recording medium of the present invention includes the following: an electrical insulating film; a ferromagnetic metal thin film, a hard carbon film, and a lubricant layer formed in the indicated order; and a back-coating layer formed on the back of the electrical insulating film. The number of dropouts is not more than 200, and the still life is not less than 10 minutes. The number of dropouts and the still life are obtained by the following measurement:

### A. Dropout measurement

the magnetic recording medium having a length of 10 m is used in a helical-scan video tape recorder combined with a digital video camera, a 3 µsec, 6 dB dropout is measured at a temperature of 23°C and a relative humidity of 70% for 10 minutes, and the average number of dropouts per minute is determined;

### B. Still life measurement

the magnetic recording medium having a length of 70 m is used in the same video tape recorder as that of the dropout measurement, a signal is recorded on the magnetic recording medium at a temperature of 23°C and a relative humidity of 70%, and then left at a temperature of 60°C and a relative humidity of 90% for 10 days, and a still life is measured at a temperature of 23°C and a relative humidity of 10%. The still life is an accelerated test of corrosion resistance.

A method for manufacturing a magnetic recording medium of the present invention is applied to the magnetic recording medium that includes the following: an electrical insulating film; a ferromagnetic metal thin film, a hard carbon film, and a lubricant layer formed in the indicated order; and a back-coating layer formed on the back of the electrical insulating film. The method includes bringing the ferromagnetic metal thin film into contact with an outermost layer of a resistance roller, the resistance roller including a conductive axis, an innermost layer, and the outermost layer, wherein a portion that is formed around the conductive axis and defined between the innermost layer and the outermost layer has a resistance gradient in its radial direction so that a resistance is low on the innermost layer side and high on the outermost layer side, supplying a reactant gas of hydrocarbon to a decompression chamber while applying a voltage to the conductive axis of the resistance roller, and forming the hard carbon film on the ferromagnetic metal thin film by plasma CVD.

An apparatus for manufacturing a magnetic recording medium of the present invention supplies a reactant gas of hydrocarbon to a decompression chamber provided with a resistance roller, and forms a hard carbon film on a ferromagnetic metal thin film formed on an electrical insulating film by plasma CVD. The resistance roller includes a conductive axis for receiving a voltage, an innermost layer, and an outermost layer. A portion that is formed around the conductive axis and defined between the innermost layer and the outermost layer has a resistance gradient in its radial direction so that a resistance is low on the innermost layer side and high on the outermost layer side.

These and other advantages of the present invention will become apparent to those skilled in the art upon reading and understanding the following detailed description with reference to the accompanying figures.
FIG. 1 is a conceptual diagram showing an example of an apparatus used in a thin film forming method of the present invention.
FIG. 2 is a cross-sectional view showing the configuration of a magnetic recording medium of the present invention.
FIG. 3 is a cross-sectional view showing the structure of a resistance roller of the present invention.
FIG. 4A is a cross-sectional view showing an example of the configuration of a resistance material of the present invention. FIG. 4B is a cross-sectional view showing another example of the configuration of a resistance material.

In the present invention, a number of dropouts of not more than 200 indicates fewer recording/reproducing defects, and a still life of not less than 10 minutes indicates higher corrosion resistance. Therefore, a magnetic recording medium of the present invention is characterized by fewer recording/reproducing defects and higher corrosion resistance.

In the present invention, the thickness of the hard carbon film formed on the ferromagnetic metal thin film is preferably 5 nm to 30 nm, and more preferably 8 nm to 15 nm. This range allows for precise and uniform recording. The hard carbon film is amorphous carbon and also known as a diamond-like carbon film.

It is preferable that the ferromagnetic metal thin film is formed by the oblique deposition of ferromagnetic metal including a Co oxide while introducing oxygen. Examples of the ferromagnetic metal thin film include Co-Ni-O, Co-Ni-Cr, and Co-Cr. The preferred thickness of the ferromagnetic metal thin film is 0.05 µm to 0.3 µm. The oblique deposition is well known in the art.

According to a manufacturing method of the present invention, the ferromagnetic metal thin film (also referred to as a "conductive layer" in the following) that is formed on one of the principal planes of an insulating base comes into contact with the outermost layer of a resistance roller. The resistance roller includes a columnar or cylindrical conductive axis and a resistance material formed around the conductive axis. The resistance material has a resistance gradient in its radial direction so that a resistance is low on the innermost layer side. A voltage is applied to the conductive axis of the resistance roller to form a thin film on the conductive layer.

In the method of the present invention, the resistance roller that comes into contact with the conductive layer has a resistance gradient so that a resistance of the resistance material located on the side face of the conductive axis is lower than a resistance of the resistance material to be in contact with the conductive layer. Therefore, the current path from the side face of the conductive axis to the resistance material can be enlarged successively toward the surface of the resistance roller. This makes it possible to correct the degree of concentration of current in the resistance roller and to achieve a uniform resistance in the contact portion between the conductive layer and the resistance material of the resistance roller. When a protective film for the conductive layer is formed by applying a voltage, the generation of Joule heat in the conductive layer and/or the insulating base can be spread and made uniform to suppress the damage to the conductive layer and/or the insulating base. Consequently, a precise protective film can be formed with high speed.

It is preferable that a specific resistance of the outermost layer of the resistance roller that comes into contact with the conductive layer is 1 Ω·cm to 500 Ω·cm. When the specific resistance is less than 1 Ω·cm, the current is likely to flow even if there are not many contact portions between the outermost layer of the resistance roller and the conductive layer. Moreover, the current may concentrate because the portions of current passage are decreased, so that Joule heat is generated locally and tends to cause defects in the insulating base and/or the conductive layer. When the specific resistance is more than 500 Ω·cm, the portions of current passage can be increased to make the current passing through the conductive layer uniform in the axial direction of the resistance roller. However, this tends to increase the Joule heat generated at the portions of current passage in the resistance roller. Therefore, the gas contained in the conductive layer, which has been formed, e.g., by vapor phase deposition, is expanded and/or released, thus reducing the adhesion strength between the insulating base and the conductive layer and/or the adhesion strength between the conductive layer and a thin film formed on the conductive layer. Accordingly, it may be difficult to form a uniform thin film on the conductive layer. By allowing the outermost layer of the resistance roller to have a specific resistance of 1 Ω·cm to 500 Ω·cm, a proper contact resistance between the conductive layer of ferromagnetic metal and the outermost layer can be achieved, and the protective film can be formed stably.

It is preferable that a specific resistance of the innermost layer of the resistance roller that is placed on a side face of the conductive axis is more than a specific resistance of the side face of the conductive axis and not more than 0.1 Ω·cm. When the specific resistance is more than 0.1 Ω·cm, the current is likely to concentrate in the vicinity of the ends of the resistance roller in the axial direction. Therefore, even if the resistance material has a resistance gradient in its thickness direction, the current passage may not be uniform over the entire contact portion between the conductive layer and the outermost layer of the resistance roller, depending on the axial length of the resistance roller. By allowing the innermost layer of the resistance roller to have a specific resistance that is more than a specific resistance of the side face of the conductive axis and not more than 0.1 Ω·cm, the current path in the resistance material of the resistance roller can be enlarged appropriately to suppress the concentration of a current supplied to the conductive layer through the outermost layer, and the protective film can be formed stably.

It is preferable that a maximum surface roughness (Rmax) of the resistance roller is 0.05 µm to 1 µm. When the maximum surface roughness is less than 0.05 µm, the adhesion between the conductive layer and the outermost layer of the resistance roller may be degraded due to either of the following reasons: the adhesion between the insulating base provided with the conductive layer and the outermost layer is extremely high, so that the degree of freedom in movement on the outermost layer is reduced; and/or the gas contained in the conductive layer, which has been formed, e.g., by vapor phase deposition, is accumulated in the boundary between the conductive layer and the outermost layer. When the maximum surface roughness is more than 1 µm, a current passage defect is likely to occur in the conductive layer and the outermost layer of the resistance roller due to either of the following reasons: the portions of current passage between the conductive layer and the outermost layer tend to be independent of each other; and/or the surface shape of the outermost layer tends to be transferred onto the conductive layer.

It is preferable that the resistance roller includes a columnar or cylindrical conductive axis coated with a resistance material. The resistance material has a resistance gradient in the thickness direction so that a specific resistance of one surface formed on the side face of the conductive axis is more than a specific resistance of the side face of the conductive axis and not more than 0.1 Ω·cm, and a specific resistance of the other surface is 1 Ω·cm to 500 Ω·cm. The use of this resistance roller can achieve high-speed stable film formation when a protective film is formed on the conductive layer by applying a voltage, and particularly when a protective film is formed on the ferromagnetic metal layer.

As described above, the present invention can improve the film quality and uniformity of a thin film that is formed on a conductive layer on an insulating base. Particularly when applied to a hard carbon film that is formed on a ferromagnetic metal thin film of a magnetic recording medium, the present invention can prevent the degradation of magnetic recording/reproducing characteristics caused by a small anomalous discharge and/or current passage defect and can achieve excellent magnetic recording/reproducing characteristics, durability, reliability, and high-speed film formation.

### Example

Hereinafter, the present invention will be described in more detail with reference to the drawings. The following example shows a magnetic recording medium that includes a ferromagnetic metal thin film as a conductive layer and a hard carbon film formed on the ferromagnetic metal thin film. The hard carbon film is produced by plasma CVD.

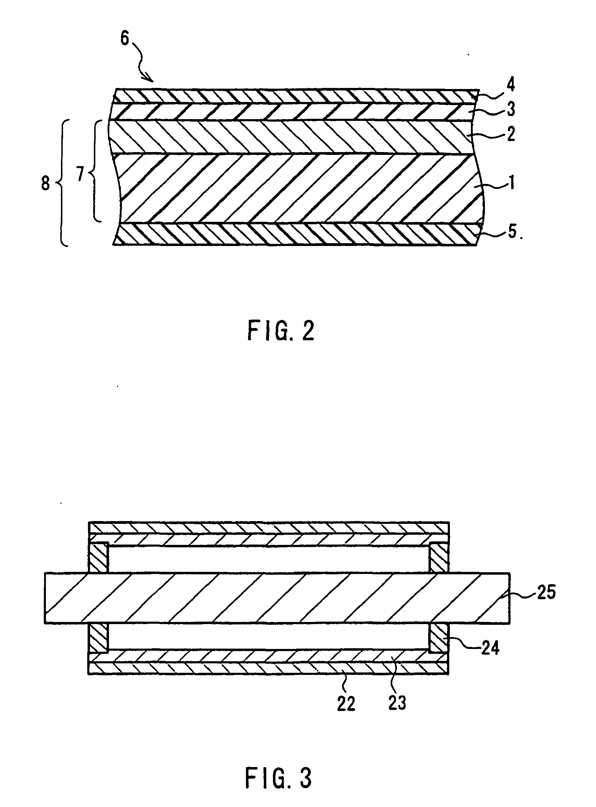

FIG. 2 shows the basic configuration of a magnetic recording medium of this example. A nonmagnetic base that has a thickness of 3 µm to 20 µm and is made of a heat-resistant flexible film such as polyethylene terephthalate (PET), polyethylene-2, 6-naphthalate (PEN), polyamide (PA), and polyimide (PI) is suitable for an electrical insulating base 1. A ferromagnetic metal thin film 2 has a thickness of 0.05 µm to 0.3 µm and is formed by the oblique deposition of ferromagnetic metal (e.g., Co) while introducing oxygen. A hard carbon film 3 is formed on the ferromagnetic metal thin film 2 to protect it. A lubricant layer 4 is formed on the hard carbon film 3 by the wet application or vacuum deposition of solid lubricant etc. A back-coating layer 5 is formed in the following manner. A mixture of a polyester resin and a lubricating substance such as carbon is prepared, and the mixture is diluted in a solvent, kneaded, and then applied by wet application. Thus, a magnetic recording medium 6 of this example is produced.

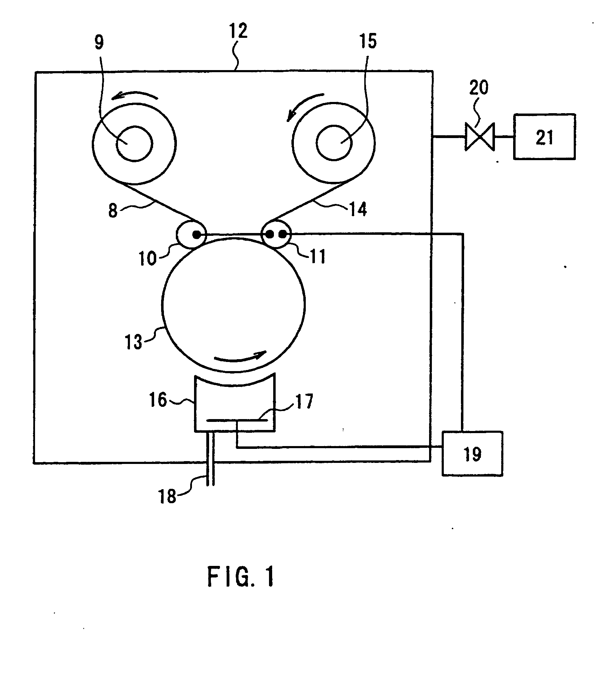

FIG. 1 schematically shows the structure of a thin film forming apparatus used in a thin film forming method of the present invention. With this apparatus, the hard carbon film 3 is formed on the ferromagnetic metal thin film 2. As shown in FIG. 2, the hard carbon film 3 can be formed on either of magnetic recording precursors 7, 8. The magnetic recording precursor 7 includes the ferromagnetic metal thin film 2 formed on the insulating nonmagnetic base 1 (referred to as "nonmagnetic base" in the following). The magnetic recording precursor 8 includes the ferromagnetic metal thin film 2 formed on one side of the nonmagnetic base 1 and the back-coating layer 5 formed on the other side thereof. In this example, the hard carbon film 3 is formed on the magnetic recording precursor 8.

In FIG. 1, the magnetic recording precursor 8 is wound around a feed roller 9 and fed from the feed roller 9 by controlling the tension. Resistance rollers 10, 11 are insulated from an apparatus body 12 and pass a current from the ferromagnetic metal thin film 2 shown in FIG. 2. The resistance roller 10 rotates in contact with the ferromagnetic metal thin film 2 of the magnetic recording precursor 8. The resistance roller 11 rotates in contact with the hard carbon film 3. The rotational speed of a main roller 13 is controlled so that the magnetic recording precursor 8 is transferred at constant speed. Although this example shows two resistance rollers 10, 11, it is also possible to use either of them. However, providing only one resistance roller 10 and a conductive or insulating roller instead of the resistance roller 11 gives rise to the following problems. When a voltage is not applied to the conductive or insulating roller (represented by 11 in FIG. 1), there is a high probability that a separation discharge occurs in a region where a magnetic recording precursor 14 provided with the hard carbon film 3 is separated from the main roller 13 and/or the roller 11. This makes the hard carbon film 3 and/or the ferromagnetic metal thin film 2 susceptible to defects. When a voltage is applied to the conductive roller, a current tends to concentrate in a region where the hard carbon film 3 comes into contact with the conductive roller. This makes the hard carbon film 3 and/or the ferromagnetic metal thin film 2 susceptible to defects. Providing only one resistance roller 11 also causes the same problems as described above. Therefore, it is desirable to use both of the resistance rollers 10, 11 as shown in FIG. 1. The magnetic recording precursor 14 after forming the hard carbon film 3 is wound continuously by a winding roller 15, and the tension is controlled in the same manner as the feed roller 9.

A discharge tube 16 is a device for forming the hard carbon film 3 by plasma CVD and includes a plasma generating electrode 17. A reactant gas of a carbon source (e.g., aliphatic having a carbon number of 1 to 12 such as alkane, alkene, and alkyne, an alicyclic compound, or an aromatic compound and a derivative of these compounds including ether, ester, etc.) is introduced individually or as a gas mixture into the discharge tube 16 through a source gas inlet 18 at pressures of 130 Pa to 0.13 Pa. The gas mixture is obtained, e.g., by adding 0.1 vol.% to 5 vol.% of hydrogen, nitrogen, oxygen, argon, or the like to 1 vol.% of the carbon source gas. A power supply 19 is connected to the electrode 17 and the resistance rollers 10, 11, and is grounded on the resistance roller side. The power supply 19 provides, e.g., a direct voltage the range of 0.5 kV to 7 kV, an alternating voltage of 1 kHz to 5 GHz in the same range of voltage, or a voltage obtained by superimposing the two voltages. The discharge tube 16, the plasma generating electrode 17, the source gas inlet 18, and the power supply 19 are used for the film formation by plasma CVD.

The apparatus body 12 is a vacuum chamber. A vacuum pump 21 is connected to the chamber via a vacuum valve 20, and the air in the chamber is evacuated by the vacuum pump 21. The capacity of the vacuum pump 21 is determined so that the vacuum degree of the apparatus body 12 is a predetermined value (e.g., 0.3 × 10⁻² Pa) in accordance with the flow rate of a gas supplied to the discharge tube 16 (i.e., the pressure in the discharge tube 16).

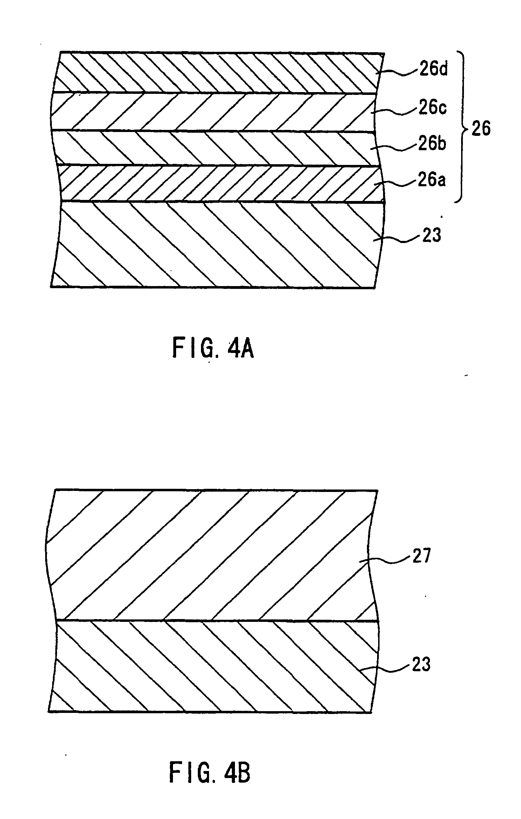

FIG. 3 is a cross-sectional view showing the configuration of the resistance rollers 10, 11. Each of the resistance rollers includes a resistance material 22, a cylindrical conductive side face 23 of an axis 25, and bearings 24 for rotatably supporting the conductive side face 23 and the axis 25. The resistance material 22 has a specific resistance that increases with an increase in distance from the bonding surface between the resistance material 22 and the conductive side face 23. That is, the electrical resistance changes so as to form a gradient in the thickness direction. Examples of the resistance material 22 include carbon, a silicon carbide, a titanium oxide (referred to as titania in the following), chromium oxide (referred to as chromina in the following), and an aluminum oxide (referred to as alumina in the following). These materials may be used individually or in combination. For example, as shown in FIG. 4A, resistance material layers 26a to 26d with different specific resistances can be stacked to produce a resistance material 26 having a gradual resistance gradient. Alternatively, as shown in FIG. 4B, resistance materials with different specific resistances can be mixed by varying the mixing ratio to produce a resistance material layer 27 having a continuous resistance gradient. The resistance material layers 26a to 26d are formed, e.g., by plasma spraying so that the electrical resistance changes step by step as follows (the whole thickness is 0.5 mm to 3 mm).
26a: all titania
26b: 80 mass% of titania and 20 mass% of chromina or alumina
26c: 50 mass% of titania and 50 mass% of chromina or alumina
26d: 20 mass% of titania and 80 mass% of chromina or alumina

The resistance material layer 27 is formed by changing the electrical resistances of the resistance material layers 26a to 26d continuously instead of a step-by-step manner.

Examples of a method for producing the resistance material 22 include thermal spraying and sputtering. The resistance gradient can be set appropriately in accordance with the resistance of a conductive layer formed on an insulating base, the value of a current flowing through the conductive layer, the thickness of a thin film formed on the conductive layer, the resistance of the thin film, or the like. The conductive side face 23, the bearings 24, and the axis 25 are good conductors with a low specific resistance. They may be formed of a single-element metal such as aluminum, copper, etc., an alloy such as stainless steel (referred to as stainless in the following), or a silicon carbide or carbon having a low specific resistance. The specific resistance of the innermost layer of the resistance material 22 that is in contact with the conductive side face 23 is preferably more than the specific resistance of the conductive side face 23 and not more than 0.1 Ω·cm. The specific resistance of the outermost layer of the resistance material 22 that is in contact with the ferromagnetic metal thin film 2 or the hard carbon film 3 is preferably 1 Ω·cm to 500 Ω·cm. The maximum surface roughness of the outermost layer of the resistance rollers 10, 11 is preferably 0.05 µm to 1 µm. The current path starts from the power supply 19 and passes through the plasma generating electrode 17, and then a plasma current flows through the magnetic recording precursor 8, the ferromagnetic metal thin film 2, and the resistance rollers 10, 11 and returns to the power supply 19. This current path is insulated from the apparatus body 12.

Next, a thin film forming method of the present invention will be described based on the apparatus shown in FIG. 1. The vacuum valve 20 is opened, and the air in the apparatus body 12 is evacuated by the vacuum pump 21 until the vacuum degree reaches a predetermined value (e.g., 1.3 × 10⁻² Pa). Then, the magnetic recording precursor 8 provided with the ferromagnetic metal thin film 2 is brought into close contact with the main roller 13 and continuously fed from the feed roller 9 to the winding roller 15. The main roller 13 transfers the magnetic recording precursor 8 that has been fed from the feed roller 9 to the position at which it is opposed to the opening (not shown) of the discharge tube 16. Thus, the magnetic recording precursor 8 is located in the film forming region of plasma CVD.

In the plasma CVD film forming region, the supply of a voltage from the power supply 19 and a source gas from the inlet 18 allows the plasma generating electrode 17 in the discharge tube 16 to generate and accelerate a plasma ion current, so that the hard carbon film 3 is formed on the ferromagnetic metal thin film 2 opposed to the plasma generating electrode 17. At this time, the current flowing through the ferromagnetic metal thin film 2 is distributed by the resistance material 22 of the resistance rollers 10, 11. The specific resistance of the resistance material 22 decreases as the current flows inside the resistance material 22, and the diameter of the resistance material 22 also decreases as it gets closer to the conductive side face 23. Therefore, the current is suppressed in a portion where the outermost layer of the resistance rollers 10, 11 comes into contact with the ferromagnetic metal thin film 2, and can be concentrated in the thickness direction of the resistance material 22. In other words, the current flows from the outermost.layer to the conductive side face 23 while maintaining its distribution, and then propagates to the axis 25 via the bearings 24. Thus, the measured resistance of the contact portion between the magnetic recording precursor 8 and the resistance rollers 10, 11 in the axial direction becomes substantially constant. Consequently, a hard carbon film 3 that is very uniform and has no current passage defect can be formed, resulting in reduced dropout and improved corrosion resistance.

Next, the present invention will be described in more detail by taking the hard carbon film 3 formed on the magnetic recording precursor 8 as example. A PET film having a width of 500 mm and a thickness of 6 µm was used as a nonmagnetic insulating base 1. A ferromagnetic metal thin film 2 of Co-O having a thickness of 0.12 µm was formed on one side of the nonmagnetic insulating base 1 by oblique deposition, and a back-coating layer 5 having a thickness of 0.5 µm in the dry state was formed on the other side by wet application, thereby producing a magnetic recording precursor 8. The back-coating layer 5 was formed in the following manner. A filler was prepared to include carbon black having an average particle diameter of about 60 nm and calcium carbonate having an average particle diameter of about 60 nm at the mass ratio of 2 : 8 (carbon black : calcium carbonate). A binder resin was prepared to include a polyester resin and nitrocellulose at the mass ratio of 1 : 1 (polyester resin : nitrocellulose). The filler and the binder were weighed and mixed at the mass ratio of 2 : 1 (filler : binder). To 15 mass% of this mixture was added 85 mass% of a solvent (toluene 50 vol.%, methyl ethyl ketone 25 vol.%, and cyclohexanone 25 vol.%), which then was applied with a gravure coater. Subsequently, the solvent was dried.

A hard carbon film 3 was formed on the ferromagnetic metal thin film 2 of the magnetic recording precursor 8 thus produced by changing the material and/or specific resistance of a resistance material 22 of resistance rollers 10, 11, by changing the material and/or specific resistance of a conductive side face 23 of the axis of the resistance rollers 10, 11, and by changing the maximum surface roughness of the outermost layer of the resistance rollers 10, 11. Thus, a magnetic recording precursor 14 was produced.

Specifically, samples 101 to 118 were produced in the following manner. A hexane gas and an argon gas were mixed at the volume ratio of 3:1. The gas mixture was supplied from the source gas inlet 18 to the discharge tube 16 at a total gas pressure of 105 Pa. A direct current (2 A, 1.2 kV) was applied from the power supply 19 to the plasma generating electrode 17. The hard carbon film 3 having a thickness of 10 nm was formed on the ferromagnetic metal thin film 2 under fixed conditions, while changing a set of resistance rollers 10, 11.

Table 1 shows the material for each of the resistance material 22 and the conductive side face 23 of the resistance rollers 10, 11 in this example. Table 2 shows the specific resistance for each of the outermost layer of the resistance material 22, the innermost layer thereof, and the conductive side face 23, and the maximum surface roughness of the outermost layer of the resistance material 22, together with the evaluation to be described later. The resistance rollers 10, 11 respectively included three layers of different specific resistances, each of which had a thickness of 1 mm (i.e., the whole thickness is 3 mm) and was produced by plasma spraying. The specific resistance of the second layer took a middle value between the specific resistance of the innermost layer and that of the outermost layer.

For comparison, samples 201 to 209 were produced in the following manner. Two rollers were used instead of the resistance rollers 10, 11 having a resistance gradient. For one roller, the same material was used in the range from the conductive side face of the axis to the outermost layer. For the other roller, a material that was different from the material for the conductive side face and had no resistance gradient was provided around the conductive side face. The hard carbon film 3 was formed on the ferromagnetic metal thin film 2 under the same conditions as described above. Table 1 shows the materials for each of the samples 201 to 209. Table 2 shows the specific resistance, the maximum surface roughness (Rmax) of the roller, and the evaluation of dropout and still life of the resultant hard carbon film 3.

**TABLE 1**

| Sample No. | Outermost layer material | Innermost layer material | Conductive side face material |
|---|---|---|---|
| 101 | Carbon (sputtering) | Carbon (sputtering) | Stainless |
| 102 | Carbon (sputtering) | Carbon (sputtering) | Silicon carbide |
| 103 | Carbon (sputtering) | Carbon (sputtering) | Stainless |
| 104 | Alumina, Titania | Titania, Alumina | Stainless |
| 105 | Alumina, Titania | Titania, Alumina | Silicon carbide |
| 106 | Alumina, Titania | Titania, Alumina | Carbon (sintering) |
| 107 | Alumina, Titania | Titania | Stainless |
| 108 | Alumina, Titania | Titania | Stainless |
| 109 | Alumina, Titania | Carbon | Stainless |
| 110 | Alumina, Titania | Titania, Alumina | Stainless |
| 111 | Alumina, Titania | Titania, Alumina | Stainless |
| 112 | Alumina, Titania | Titania | Stainless |
| 113 | Alumina, Titania | Carbon | Stainless |
| 114 | Alumina, Titania | Titania | Stainless |
| 115 | Chromina, Titania | Titania, Chromina | Stainless |
| 116 | Chromina, Titania | Titania, Chromina | Silicon carbide |
| 117 | Chromina, Titania | Titania, Chromina | Stainless |
| 118 | Chromina, Titania | Titania, Chromina | Stainless |
| 201* | Stainless | Stainless | Stainless |
| 202* | Carbon | Carbon | Carbon |
| 203* | Silicon carbide | Silicon carbide | Silicon carbide |
| 204* | Silicon carbide | Silicon carbide | Silicon carbide |
| 205* | Carbon (sputtering) | Carbon (sputtering) | Stainless |
| 206* | Alumina, Titania | Alumina, Titania | Carbon |
| 207* | Alumina, Titania | Alumina, Titania | Stainless |
| 208* | Alumina, Titania | Alumina, Titania | Stainless |
| 209* | Chromina, Titania | Chromina, Titania | Stainless |

| | | | |
|---|---|---|---|
| Note: Comparative examples are marked with *. | | | |

To evaluate the film quality of the hard carbon film 3 formed using the rollers of the samples 101 to 118 and 201 to 209, the following experiments were conducted. A fluorine-containing carboxylic acid amine salt expressed by the following formula was formed on the hard carbon film 3 of the magnetic recording precursor 14 to a thickness of about 4 nm as a lubricant layer 4 by wet application, which then was cut to a width of 6.35 mm, thus providing a magnetic recording medium 6. This coating was dissolved in a solvent such as tetrahydrofuran, and the solution was applied and dried. The fluorine-containing carboxylic acid amine salt and its synthetic method are disclosed in U.S. Patent No. 5,604,032 and EP Patent No. 0652206 B1.

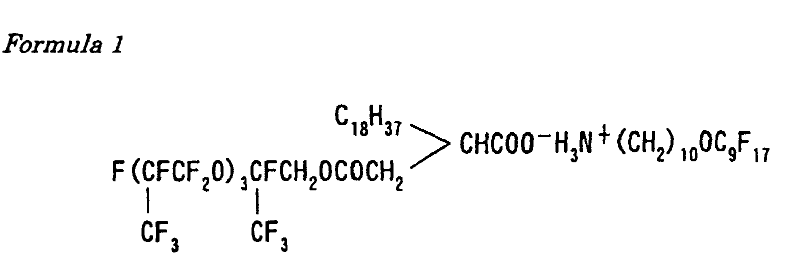

Then, the magnetic recording medium 6 having a length of about 10 m was set in a digital video camera (referred to as DVC in the following) cassette. A commercial DVC-VTR ("NV-GS27" manufactured by Matsushita Electric Industrial Co., Ltd., a helical-scan video tape recorder carrying a small cylinder) was modified so that the output of the head was sent to the outside. Using the modified DVC-VTR, a 3 µsec, 6 dB dropout was measured at a temperature of 23°C and a relative humidity of 70% for 10 minutes. The average number of dropouts per minute was taken as a measured value, and when the measured value was not more than 200, the magnetic recording medium was recognized to have acceptable quality. This measurement was performed at 10 locations in the width direction, of which the largest number of dropouts was employed. Moreover, the corrosion resistance was evaluated by using the magnetic recording medium 6 having a length of about 70 m and the same DVC cassette and DVC-VTR as those in the dropout measurement. A signal was recorded on the magnetic recording medium at a temperature of 23°C and a relative humidity of 70%, and then left at a temperature of 60°C and a relative humidity of 90% for 10 days. Thereafter, the still life was measured at a temperature of 23°C and a relative humidity of 10%, and when the still life was not less than 10 minutes, the magnetic recording medium was recognized to have acceptable quality.

**TABLE 2**

| Sample No. | Specific resistance of outermost layer (Ω·cm) | Specific resistance of innermost layer (Ω·cm) | Specific resistance of conductive side face (Ω·cm) | Rmax (µm) | Number of dropouts/min. | Still life (min.) |
|---|---|---|---|---|---|---|
| 101 | 1 | 1 × 10⁻¹ | < 1 × 10⁻⁵ | 0.5 | 200 | 12 |
| 102 | 5 | 1 × 10⁻¹ | ≒ 1 × 10⁻² | 0.5 | 195 | 13 |
| 103 | 5 | 1 × 10⁻¹ | < 1 × 10⁻⁵ | 0.5 | 180 | 13 |
| 104 | 1 × 10 | 5 × 10⁻² | < 1 × 10⁻⁵ | 0.5 | 120 | 20 |
| 105 | 5 × 10 | 5 × 10⁻² | ≒ 1 × 10⁻² | 0.5 | 160 | 25 |
| 106 | 5 × 10 | 5 × 10⁻² | ≒ 1 × 10⁻³ | 0.5 | 140 | 23 |
| 107 | 5 × 10 | 1 × 10⁻² | < 1 × 10⁻⁵ | 0.05 | 90 | 12 |
| 108 | 5 × 10 | 1 × 10⁻² | < 1 × 10⁻⁵ | 0.1 | 80 | 25 |
| 109 | 5 × 10 | ≒ 1 × 10⁻³ | < 1 × 10⁻⁵ | 0.1 | 70 | 35 |
| 110 | 5 × 10 | 1.5 × 10⁻² | < 1 × 10⁻⁵ | 0.5 | 95 | 25 |
| 111 | 5 × 10 | 1 × 10⁻¹ | < 1 × 10⁻⁵ | 0.5 | 90 | 27 |
| 112 | 5 × 10 | 1 × 10⁻² | < 1 × 10⁻⁵ | 0.5 | 80 | 30 |
| 113 | 5 × 10 | ≒ 1 × 10⁻³ | < 1 × 10⁻⁵ | 0.5 | 70 | 35 |
| 114 | 5 × 10 | 5 × 10⁻² | < 1 × 10⁻⁵ | 1.0 | 180 | 25 |
| 115 | 1 × 10² | 5 × 10⁻² | < 1 × 10⁻⁵ | 0.5 | 80 | 25 |
| 116 | 2 × 10² | 5 × 10-2 | ≒ 1 × 10⁻² | 0.5 | 75 | 16 |
| 117 | 2 × 10² | 5 × 10⁻² | < 1 × 10⁻⁵ | 0.5 | 70 | 16 |
| 118 | 5 × 102 | 5 × 10⁻² | < 1 × 10⁻⁵ | 0.5 | 80 | 10 |
| 201* | <1 × 10⁻⁵ | < 1 × 10⁻⁵ | < 1 × 10⁻⁵ | 0.5 | > 10000 | < 1 |
| 202* | ≒ 1 × 10⁻³ | ≒ 1 × 10⁻³ | ≒ 1 × 10⁻³ | 0.5 | 500 | 3 |
| 203* | 5 × 10 | 5 × 10 | 5 × 10 | 0.5 | 300 | 8 |
| 204* | 5 × 10² | 5 × 10² | 5 × 10² | 0.5 | 220 | 6 |
| 205* | 9 × 10⁻¹ | 9 × 10⁻¹ | < 1 × 10⁻⁵ | 0.5 | 250 | 10 |
| 206* | 5 × 10 | 5 × 10 | ≒ 1 × 10⁻³ | 0.5 | 220 | 13 |
| 207* | 5 × 10 | 5 × 10 | < 1 × 10⁻⁵ | 0.04 | 90 | 9 |
| 208* | 5 × 10 | 5 × 10 | < 1 × 10⁻⁶ | 1.1 | 210 | 23 |
| 209* | 5.1 × 10² | 5.1 × 10² | < 1 × 10⁻⁵ | 0.5 | 80 | 8 |

| | | | | | | |
|---|---|---|---|---|---|---|
| Note: Comparative examples are marked with *. | | | | | | |

The effect of improving dropout is increased with an increase in specific resistance of the outermost layer. Comparing the samples 201 to 203 indicates that this effect is obtained when the specific resistance is not less than 1 Ω·cm. Moreover, comparing the sample 209 with the sample 118 indicates that the specific resistance is preferably not more than 500 Ω·cm. The reason that the specific resistance of the outermost layer has the proper range is not clear and can be considered as follows. When the specific resistance of the outermost layer is low, fewer points of current passage are necessary. Therefore, the current density per point is increased to cause damage or defect in the nonmagnetic insulating base 1 or the ferromagnetic metal thin film 2 due to Joule heat. This leads to an increase in recording/reproducing defects (i.e., an increase in the number of dropouts). Moreover, a pinhole is generated in the hard carbon film 3 formed on the defective portion of the ferromagnetic metal thin film 2 and may cause the ferromagnetic metal thin film 2 to oxidize. In contrast, when the specific resistance of the outermost layer is high, the points of current passage are increased. However, the resistance per point becomes larger, so that either or both of the resistance rollers 10, 11 generate heat. Therefore, the gas contained in the ferromagnetic metal thin film 2, which has been formed by vapor phase deposition, is released (outgassed) and tends to slightly reduce the adhesion strength between the hard carbon film 3 and the ferromagnetic metal thin film 2.

The suitable specific resistance of the innermost layer is not more than 0.1 Ω·cm. A higher specific resistance of the innermost layer makes it difficult for the current to flow through the ferromagnetic metal thin film 2 over the entire portion in the axial direction of the resistance rollers 10, 11. Therefore, the current concentrates slightly at the ends of the resistance rollers 10, 11 in the axial direction, which is likely to cause a small increase in recording/reproducing defects. The innermost layer may be formed of a material having a larger specific resistance than that of the conductive side face 23. More resistance to the passage of a current supplied from the power source 19 can be suppressed as the specific resistance of the innermost layer is closer to that of the conductive side face 23. Thus, the specific resistance of the innermost layer is selected appropriately in accordance with the specific resistance of the outermost layer and the thickness of the resistance material 22 of the resistance rollers 10, 11.

The suitable maximum surface roughness of the outermost layer of the resistance rollers 10, 11 ranges from 0.05 µm to 1.0 µm. When the maximum surface roughness is large, the surface shape is transferred onto the ferromagnetic metal thin film 2 and/or the nonmagnetic insulating base 1, or the points of current passage between the outermost layer of the resistance rollers 10, 11 and the ferromagnetic metal thin film 2 are independent of each other. This makes it difficult to ensure uniform current passage and tends to increase the recording/reproducing defects. When the maximum surface roughness is too small, the corrosion resistance (i.e., the still life) is reduced. This problem is ascribed to either of the following reasons: the nonmagnetic insulating base 1 provided with the ferromagnetic metal thin film 2 cannot move freely on the surface of the resistance rollers 10, 11, so that the adhesion strength becomes poor; or the gas contained in the ferromagnetic metal thin film 2 is not released (outgassed) completely from the contact surface between the ferromagnetic metal thin film 2 and the resistance rollers 10, 11.

In either case, as can be seen from Table 2, the samples 101 to 118 of the present invention can achieve a significant improvement in both recording/reproducing defects (evaluated by dropout) and corrosion resistance (evaluated by still life) compared with the samples 201 to 209. The effect of improving these characteristics becomes more pronounced particularly when compared to the samples 201 to 204, which used the same material in the range from the conductive side face to the outermost layer of the roller.

The above example describes the magnetic recording medium in detail. However, the present invention also can be applied to a semiconductor that includes a conductor and an insulating layer, a printed wiring board, and a liquid crystal conductive film.

## Claims

1. A method for manufacturing a magnetic recording medium, comprising:
an electrical insulating film (1), a ferromagnetic metal thin film (2), a hard carbon film (3), a lubricant layer (4) formed in the indicated order; and a back-coating layer (5) formed on the back of the electrical insulating film (1), wherein said method comprises the steps:
bringing the ferromagnetic metal thin film (2) into contact with an outermost layer (22) of a first resistance roller (10),
supplying a reactant gas of hydrocarbon to a decompression chamber (12),
forming the hard carbon film (3) on the ferromagnetic metal thin film (2) by plasma CVD, while applying a voltage to the conductive axis of the resistance roller,
**characterized in that**
the resistance roller comprises a conductive axis (25), an innermost layer (23), and the outermost layer (22), wherein a portion that is formed around the conductive axis (25) and defined between the innermost layer (23) and the outermost layer (22) has a resistance gradient in its radial direction so that a resistance is low on the innermost layer side and high on the outermost layer side.

2. Method according to claim 1, further comprising the step of bringing the hard carbon film (3) into contact with a second resistance roller (11) having the same features as the first resistance roller (10).

3. Method according to claim 1 or 2, wherein a specific resistance of the outermost layer (22) of the resistance roller (10, 11) that comes into contact with the ferromagnetic metal thin film (2) or the hard carbon film (3) is 1 Ω · cm to 500 Ω · cm.

4. Method according to claim 1, 2 or 3, wherein a specific resistance of the innermost layer (23) of the resistance roller (10, 11) that is placed on a side face of the conductive axis (25) is more than a specific resistance of the side face of the conductive axis and not more than 0.1 Ω· cm.

5. Method according to any of claims 1 to 4, wherein a maximum surface roughness (Rmax) of the resistance roller (10, 11) is 0.05 µm to 1 *µ*m.

6. Method according to any of claims 1 to 5, wherein the resistance gradient in the radial direction of the resistance roller (10, 11) changes step by step or continuously.

7. Method according to any of claims 1 to 6, wherein the electrical insulating film (1) is a resin film selected from the group consisting of a polyester film, a polyamide film, and a polyimide film.

8. Method according to any of claims 1 to 7, wherein the ferromagnetic metal thin film (2) is formed by oblique deposition of ferromagnetic metal including a Co oxide while introducing oxygen.

9. Method according to any of claims 1 to 8, wherein the ferromagnetic metal thin film (2) has a thickness of 0.05 *µ*m to 0.3 *µ*m.

10. Method according to any of claims 1 to 9, wherein the hard carbon film (3) has a thickness of 5 nm to 30 nm.

11. An apparatus for manufacturing a magnetic recording medium, comprising
means (18) for supplying a reactant gas of hydrocarbon to a decompression chamber (12),
means (16) for forming a hard carbon film (3) on a ferromagnetic metal thin film (2) formed on an electrical insulating film (1) by plasma CVD,
a first resistance roller (10) for contacting the ferromagnetic metal thin film (2),
**characterized in that**
the resistance roller (10) comprises a conductive axis (25) for receiving a voltage, an innermost layer (23), and an outermost layer (22), and a portion that is formed around the conductive axis (25) and defined between the innermost layer (23) and the outermost layer (22) has a resistance gradient in its radial direction so that a resistance is low on the innermost layer side and high on the outermost layer side.

12. Apparatus according to claim 11, further comprising a second resistance roller (11) having the same features as the first resistance roller (10) for contacting the hard carbon film (3).

## Patentansprüche

1. Verfahren zum Herstellen eines magnetischen Aufzeichnungsmediums, das aufweist:
einen elektrischen Isolierfilm (1), einen ferromagnetischen Metalldünnfilm (2), einen harten Kohlenstoff-Film (3), eine Schmiermittelschicht (4), die in der angegebenen Reihenfolge gebildet werden; und eine Rückenüberzugsschicht (5), die auf der Rückseite des elektrischen Isolierfilms (1) gebildet wird, wobei das Verfahren die Schritte aufweist:
Bringen des ferromagnetischen Metalldünnfilms (2) in Kontakt mit einer äußersten Schicht (22) einer ersten Widerstandsrolle (10),
Zuführen eines Reaktantgases aus Kohlenwasserstoff in eine Dekompressionskammer (12),
Bilden des harten Kohlenstoff-Films (3) auf dem ferromagnetischen Metalldünnfilm (2) durch Plasma-CVD, während eine Spannung an die leitfähige Achse der Widerstandsrolle angelegt wird,
**dadurch gekennzeichnet, daß**
die Widerstandsrolle eine leitfähige Achse (25), eine innerste Schicht (23) und die äußerste Schicht (22) aufweist, wobei ein Abschnitt, der um die leitfähige Achse (25) ausgebildet und zwischen der innersten Schicht (23) und der äußersten Schicht (22) definiert ist, einen Widerstandsgradienten in seine radiale Richtung aufweist, so daß ein Widerstand auf der Seite der innersten Schicht niedrig und auf der Seite der äußersten Schicht hoch ist.

2. Verfahren nach Anspruch 1, das ferner den Schritt aufweist, den harten Kohlenstoff-Film (3) mit einer zweiten Widerstandsrolle (11) in Kontakt zu bringen, die dieselben Merkmale wie die erste Widerstandsrolle (10) aufweist.

3. Verfahren nach Anspruch 1 oder 2, wobei ein spezifischer Widerstand der äußersten Schicht (22) der Widerstandsrolle (10, 11), die mit dem ferromagnetischen Metalldünnfilm (2) oder dem harten Kohlenstoff-Film (3) in Kontakt kommt, 1 Ω·cm bis 500 Ω·cm beträgt.

4. Verfahren nach Anspruch 1, 2 oder 3, wobei ein spezifischer Widerstand der innersten Schicht (23) der Widerstandsrolle (10, 11), die auf einer Seitenfläche der leitfähigen Achse (25) angeordnet ist, größer als ein spezifischer Widerstand der Seitenfläche der leitfähigen Achse ist und nicht höher als 0,1 Ω·cm ist.

5. Verfahren nach einem der Ansprüche 1 bis 4, wobei eine maximale Oberflächenrauhigkeit (Rmax) der Widerstandsrolle (10, 11) 0,05 µm bis 1 µm beträgt.

6. Verfahren nach einem der Ansprüche 1 bis 5, wobei der Widerstandsgradient in die radiale Richtung der Widerstandsrolle (10, 11) sich schrittweise oder kontinuierlich ändert.

7. Verfahren nach einem der Ansprüche 1 bis 6, wobei der elektrische Isolierfilm (1) ein Harzfilm ist, der aus der Gruppe ausgewählt wird, die aus einem Polyesterfilm, einem Polyamidfilm und einem Polyimidfilm besteht.

8. Verfahren nach einem der Ansprüche 1 bis 7, wobei der ferromagnetische Metalldünnfilm (2) durch Schrägabscheidung von ferromagnetischem Metall gebildet wird, das ein Co-Oxid enthält, während Sauerstoff eingeleitet wird.

9. Verfahren nach einem der Ansprüche 1 bis 8, wobei der ferromagnetische Metalldünnfilm (2) eine Dicke von 0,05 µm bis 0,3 µm aufweist.

10. Verfahren nach einem der Ansprüche 1 bis 9, wobei der harte Kohlenstoff-Film (3) eine Dicke von 5 nm bis 30 nm aufweist.

11. Vorrichtung zur Herstellung eines magnetischen Aufzeichnungsmediums, die aufweist
eine Einrichtung (18) zur Zuführung eines Reaktantgases aus Kohlenwasserstoff in eine Dekompressionskammer (12),
eine Einrichtung (16) zur Bildung eines harten Kohlenstoff-Films (3) auf einem ferromagnetischen Metalldünnfilm (2), der auf einem elektrischen Isolierfilm (1) durch Plasma-CVD gebildet wird,
eine erste Widerstandsrolle (10) zur Berührung des ferromagnetischen Metalldünnfilms (2),
**dadurch gekennzeichnet, daß**
die Widerstandsrolle (10) eine leitfähige Achse (25) zur Aufnahme einer Spannung, eine innerste Schicht (23) und eine äußerste Schicht (22) aufweist, und ein Abschnitt, der um die leitfähige Achse (25) ausgebildet ist und zwischen der innersten Schicht (23) und der äußersten Schicht (22) definiert ist, in seine radiale Richtung einen Widerstandsgradienten aufweist, so daß ein Widerstand auf der Seite der innersten Schicht niedrig und auf der Seite der äußersten Schicht hoch ist.

12. Vorrichtung nach Anspruch 11, die ferner eine zweite Widerstandsrolle (11) mit denselben Merkmalen wie die erste Widerstandsrolle (10) zur Berührung des harten Kohlenstoff-Films (3) aufweist.

## Revendications

1. Procédé pour la fabrication d'un support d'enregistrement magnétique, comprenant :
un film isolant électrique (1), un film mince métallique ferromagnétique (2), un film de carbone dur (3), une couche de lubrifiant (4) formée dans l'ordre indiqué ; et une couche de revêtement dorsal (5) formée sur le dos du film isolant électrique (1), dans lequel ledit procédé comprend les étapes consistant à :
amener le film mince métallique ferromagnétique (2) en contact avec une couche la plus à l'extérieur (22) d'un premier rouleau de résistance (10),
fournir un gaz réactif d'hydrocarbure à une chambre de décompression (12),
former le film de carbone dur (3) sur le film mince métallique ferromagnétique (2) par CVD au plasma, tout en appliquant une tension à l'axe conducteur du rouleau de résistance,
**caractérisé en ce que**
le rouleau de résistance comprend un axe conducteur (25), une couche la plus à l'intérieur (23), et la couche la plus à l'extérieur (22), dans laquelle une partie qui est formée autour de l'axe conducteur (25) et définie entre la couche la plus à l'intérieur (23) et la couche la plus à l'extérieur (22) présente un gradient de résistance dans sa direction radiale de sorte qu'une résistance est faible sur le côté couche la plus à l'intérieur et élevée sur le côté couche la plus à l'extérieur.

2. Procédé selon la revendication 1, comprenant, en outre, l'étape consistant à amener le film de carbone dur (3) en contact avec un second rouleau de résistance (11) ayant les mêmes caractéristiques que le premier rouleau de résistance (10).

3. Procédé selon la revendication 1 ou 2, dans lequel une résistance spécifique de la couche la plus à l'extérieur (22) du rouleau de résistance (10, 11) qui vient en contact avec le film mince métallique ferromagnétique (2) ou le film de carbone dur (3) est de 1 Ω · cm à 500 Ω · cm

4. Procédé selon la revendication 1, 2 ou 3, dans lequel une résistance spécifique de la couche la plus à l'intérieur (23) du rouleau de résistance (10, 11) qui est placé sur une face latérale de l'axe conducteur (25) est plus grande qu'une résistance spécifique de la face latérale de l'axe conducteur et n'est pas supérieure à 0,1 Ω · cm.

5. Procédé selon l'une quelconque des revendications 1 à 4, dans lequel une rugosité en surface maximale (Rmax) du rouleau de résistance (10, 11) est de 0,05 µm à 1 µm.

6. Procédé selon l'une quelconque des revendications 1 à 5, dans lequel le gradient de résistance dans la direction radiale du rouleau de résistance (10, 11) change pas par pas ou continuellement.

7. Procédé selon l'une quelconque des revendications 1 à 6, dans lequel le film isolant électrique (1) est un film de résine choisi dans le groupe constitué d'un film de polyester, d'un film polyamide et d'un film polyimide.

8. Procédé selon l'une quelconque des revendications 1 à 7, dans lequel le film mince métallique ferromagnétique (2) est formé par dépôt oblique d'un métal ferromagnétique incluant un oxyde de Co tout en introduisant de l'oxygène.

9. Procédé selon l'une quelconque des revendications 1 à 8, dans lequel le film mince métallique ferromagnétique (2) présente une épaisseur de 0,05 µm à 0,3 µm.

10. Procédé selon l'une quelconque des revendications 1 à 9, dans lequel le film de carbone dur (3) présente une épaisseur de 5 nm à 30 nm.

11. Appareil pour la fabrication d'un support d'enregistrement magnétique, comprenant
un moyen (18) pour fournir un gaz réactif d'hydrocarbure à une chambre de décompression (12);
un moyen (16) pour former un film de carbone dur (3) sur un film mince métallique ferromagnétique (2) formé sur un film isolant électrique (1) par CVD plasma,
un premier rouleau de résistance (10) pour contacter le film mince métallique ferromagnétique (2),
**caractérisé en ce que**
le rouleau de résistance (10) comprend un axe conducteur (25) pour recevoir une tension, une couche la plus à l'intérieur (23), et une couche la plus à l'extérieur (22), et une partie qui est formée autour de l'axe conducteur (25) et définie entre la couche la plus à l'intérieur (23) et la couche la plus à l'extérieur (22) présente un gradient de résistance dans sa direction radiale de sorte qu'une résistance est faible sur le côté couche la plus à l'intérieur et élevée sur le côté couche la plus à l'extérieur.

12. Appareil selon la revendication 11, comprenant en outre, un second rouleau de résistance (11) ayant les mêmes caractéristiques que le premier rouleau de résistance (10) pour contacter le film de carbone dur (3).
